# EUROPÄISCHE PATENTANMELDUNG

(11) **EP 1 670 077 A1**
(43) Veröffentlichungstag der Anmeldung: **14.06.2006**
(21) Anmeldenummer: 04029322.7
(22) Anmeldetag: 10.12.2004
(51) Int. Cl.: H01L 35/30, H01L 23/38

(54) **Halbleiter-Schaltungsanordnung mit Energierückgewinnung**

(71) Anmelder: SIEMENS AKTIENGESELLSCHAFT, 80333 München (DE)
(72) Erfinder: Braam, Reinhold, 46414 Rhede (DE); Hülskemper, Michael, 46569 Hünxe (DE); Rösen, Benedikt, 46459 Rees (DE); Serajl, Gholam Ali, 46397 Bocholt (DE)

(57) **Zusammenfassung**

Die Erfindung bezieht sich auf eine Halbleiter-Schaltungsanordnung mit integrierten Halbleiter-Schaltungselementen in einem Halbleiter-Chip (1),
wobei,
dass auf wenigstens einer Seite des Chips (1), elektrisch isoliert von den Schaltungselementen eine thermisch leitfähige Platte (2) vorgesehen ist, die über eine Mehrzahl von Wärmeleitelementen thermisch an den Chip (1) gekoppelt ist,
auf der dem Chip (1) abgewandten Seite der Platte (2) eine Reihenschaltung (5) von Seebeck-Elementen vorgesehen ist, die jeweils eine erste Wärmekontaktfläche (6), die thermisch mit der Platte (2) gekoppelt ist, und eine zweite Wärmekontaktfläche (7) aufweisen, die thermisch mit einem Wärmereservoir gekoppelt ist, und
elektrische Kontakte (8, 9) für einen Abgriff einer von der Reihenschaltung (5) von Seebeck-Elementen gelieferten Thermospannung (V₁, V₂) vorgesehen sind.

## Beschreibung

Die Erfindung bezieht sich auf eine Halbleiter-Schaltungsanordnung mit integrierten Halbleiter-Schaltungselementen in einem Halbleiter-Chip sowie auf eine Kombination der Halbleiter-Schaltungsanordnung mit einem Akkumulator.

Integrierte Halbleiter-Schaltungsanordnungen finden in der Technik vielfältige Anwendung. Mit einer Erhöhung des Integrationsgrades zeigen solche Halbleiter-Schaltungsanordnungen die Problematik, dass eine Temperatur der Halbleiter-Schaltungsanordnung in Folge eines Stromdurchflusses der Halbleiter-Schaltungselemente ansteigt. Dabei kann der sich ergebende Temperaturanstieg derart groß sein, dass eine Kühlung der Halbleiter-Schaltungsanordnung erforderlich wird, um eine zufrieden stellende Funktionsfähigkeit der Schaltungsanordnung zu gewährleisten.

Zu diesem Zweck ist es im Stand der Technik bekannt, beispielsweise mit Hilfe einer Peltier-Kühlung, eine gewünschte Betriebstemperatur für die Halbleiter-Schaltungsanordnung bereitzustellen. Es verbleibt jedoch das Problem, dass bei einem Betrieb der Halbleiter-Schaltungsanordnung durch die Entstehung von Verlustwärme Energie verloren geht.

Ausgehend hiervon liegt der Erfindung die Aufgabe zugrunde, eine Halbleiter-Schaltungsanordnung der eingangs genannten Art bereitzustellen, bei der eine auftretende Verlustenergie vermindert ist, sowie eine Kombination aus einer Halbleiter-Schaltungsanordnung und einem Akkumulator anzugeben, die zum Vermindern von Verlustenergie zusammenwirken.

Die Aufgabe wird gelöst durch die Gegenstände der unabhängigen Patentansprüche 1 und 9.

Hinsichtlich der Halbleiter-Schaltungsanordnung mit integrierten Halbleiter-Schaltungselementen in einem Halbleiter-Chip ist danach vorgesehen, dass auf wenigstens einer Seite des Chips, elektrisch isoliert von den Schaltungselementen eine thermisch leitfähige Platte vorgesehen ist, die über eine Mehrzahl von Wärmeleitelementen thermisch an den Chip gekoppelt ist,
auf der dem Chip abgewandten Seite der Platte eine Reihenschaltung von Seebeck-Elementen vorgesehen ist, die jeweils eine erste Wärmekontaktfläche, die thermisch mit der Platte gekoppelt ist, und eine zweite Wärmekontaktfläche aufweisen, die thermisch mit einem Wärmereservoir gekoppelt ist, und
elektrische Kontakte für einen Abgriff einer von der Reihenschaltung von Seebeck-Elementen gelieferten Thermospannung vorgesehen sind.

Die Halbleiteranordnung nutzt somit das bekannte thermoelektrische Prinzip aus, bei dem im Rahmen des Seebeck-Effektes eine Thermospannung bereitgestellt wird, wenn verschiedene Wärmekontaktflächen der Seebeck-Elemente unterschiedliche Temperaturen aufweisen. Durch die Reihenschaltung von Seebeck-Elementen ergibt sich eine Aufsummierung der einzelnen Thermospannungen zu einer Gesamtspannung, die an den vorgesehenen elektrischen Kontakten abgegriffen werden kann. Die elektrischen Kontakte ermöglichen es, die in Form elektrischer Energie bereit gestellte, wieder gewonnene Energie auszukoppeln und zu Energieversorgungszwecken auszunutzen.

Die Wärmeleitelemente können bevorzugt als Nano-Röhrchen ausgebildet sein, wobei darauf hinzuweisen ist, dass Nano-Röhrchen sich durch eine besonders hohe thermische Leitfähigkeit auszeichnen. Auf diese Weise kann in dem Chip entstehende Wärme, die sonst von dem Chip als Verlustwärme abgestrahlt werden würde, durch die Wärmeleitelemente zu der thermisch leitfähigen Platte transportiert werden, die mit den ersten Wärmekontaktflächen der Seebeck-Elemente thermisch verbunden ist.

Bei einem bevorzugten Ausführungsbeispiel kann vorgesehen sein, dass mehrere Wärmeleitelemente gemeinsam ein Bündel bilden, wobei die Wärmeleitelemente eines Bündels verschieden weit in den Chip hineinragen.

Durch das unterschiedlich weite Hineinragen der einzelnen Wärmeleitelemente eines Bündels ist es möglich, aus verschieden tief gelegenen Schichten innerhalb des Chips die dort vorliegende Wärmemenge über die Wärmeleitelemente zu der Platte zu transportieren. Allgemein können die Wärmeleitelemente im Wesentlichen gleichmäßig, selbstverständlich unter Berücksichtigung vorhandener Halbleiter-Schaltungselemente, zwischen der Platte und dem Halbleiter-Chip verteilt sein.

Bevorzugt kann die Platte aus einer Keramik hergestellt sein, die sich durch eine besonders gute Wärmeleitfähigkeit auszeichnet.

Die Reihenschaltung von Seebeck-Elementen (Thermowände) kann entlang einer Linie angeordnet sein, so dass zur Verfügung stehender Platz auf der wärmeleitfähigen Platte gut ausgenutzt wird. Bei einer Weiterentwicklung dieser Ausführungsform kann vorgesehen sein, dass parallel zu der Reihenschaltung von Seebeck-Elementen angeordnete weitere Reihenschaltungen von Seebeck-Elementen vorgesehen sind. Auf diese Weise kann unter Einhaltung erforderlicher Abstände zwischen den Reihenschaltungen von Seebeck-Elementen eine gesamte Oberfläche der wärmeleitfähigen Platte mit Reihenschaltungen von Seebeck-Elementen bedeckt werden, so dass ein besonders hoher Grad für die Wiedergewinnung von Energie mit Hilfe des Seebeck-Effektes erreicht wird.

Zum Erzeugen einer besonders hohen Thermospannung können die Reihenschaltungen von Seebeck-Elementen unter sich in Reihe geschaltet sein. Ebenso ist es möglich, die Reihenschaltungen von Seebeck-Elementen unter sich parallel zueinander zu schalten, so dass zwar eine geringere Ladespannung erzeugt wird, der Ladestrom jedoch erhöht ist gegenüber der Ausführungsform mit in Reihe zueinander geschalteten Reihen von Seebeck-Elementen.

Die oben genannte Aufgabe wird ebenso gelöst durch eine Kombination aus einer Halbleiter-Schaltungsanordnung, wie sie oben in verschiedenen Ausführungsformen dargestellt ist, und einem Akkumulator, dessen Anschlüsse jeweils mit elektrischen Kontakten der Halbleiter-Schaltungsanordnung verbunden sind. Diese Kombination gestattet es, den Akkumulator mit Hilfe einer Thermospannung aufzuladen, der von den Reihenschaltungen von Seebeck-Elementen bereitgestellt wird.

Bevorzugt kann es sich bei dem Akkumulator um denjenigen handeln, der zur Energieversorgung der Halbleiter-Schaltungsanordnung dient.

Besonders hervorzuheben ist dabei, dass der Akkumulator zur Energieversorgung eines Mobiltelefons dienen kann. Der bei diesem Gerät verwendete Halbleiter-Chip kann derart ausgestattet sein, wie oben anhand der Halbleiter-Schaltungsanordnung erläutert. Der gelieferte Ladestrom von den Reihenschaltungen von Seebeck-Elementen dient dann zum Aufladen des Mobiltelefon-Akkumulators, so dass die wieder gewonnene elektrische Energie als Betriebsenergie für das Mobiltelefon verwendet werden kann. Dadurch erhöht sich der Wirkungsgrad für die Energieversorgung des Mobiltelefons erheblich.

Es ist darauf hinzuweisen, dass die Erfindung selbstverständlich nicht auf einen Einsatz bei Mobiltelefonen beschränkt ist sondern sämtliche Geräte betrifft, die mit einer Halbleiter-Schaltungsanordnung der oben angesprochenen Art ausgestattet sind, wie Prozessoren aller Art.

Die Erfindung wird nachfolgend anhand eines Ausführungsbeispiels unter Bezugnahme auf die Zeichnung noch näher erläutert. Es zeigen:
- Figur 1: eine Halbleiter-Schaltungsanordnung mit Energierückgewinnung in einer Schnittansicht,
- Figur 2: die Halbleiter-Schaltungsanordnung von Figur 1 in einer Ansicht von oben,
- Figur 3: eine Reihenschaltung von Seebeck-Elementen,
- Figur 4: eine Schaltungs-Anordnung einer Kombination einer Halbleiter-Schaltungsanordnung mit einem Akkumulator,
- Figur 5: eine zu der Schaltungs-Anordnung von Figur 4 alternative Schaltungs-Anordnung.

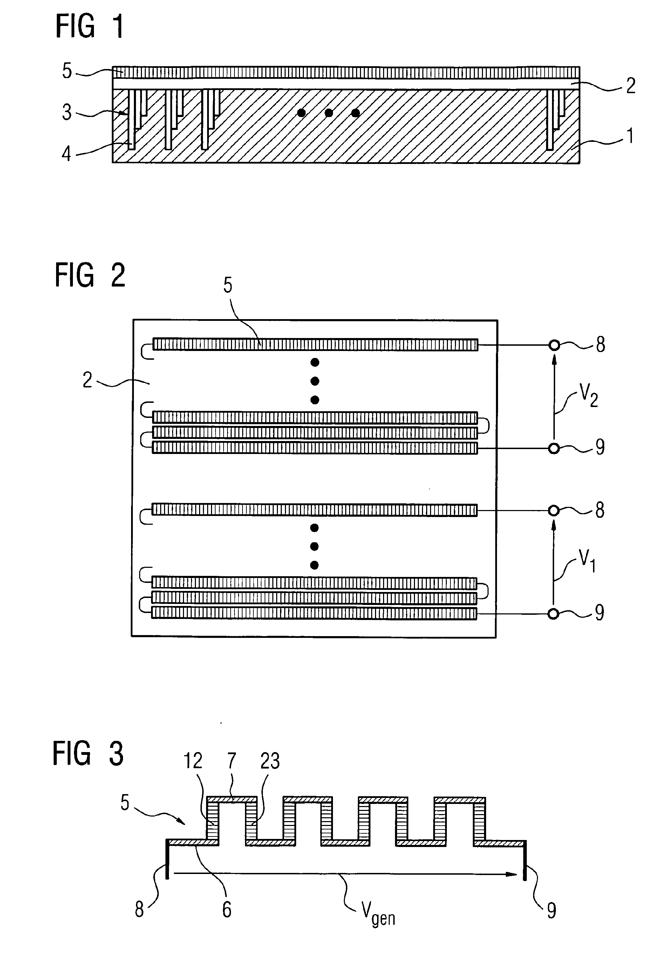

Der Figur 1 ist der allgemeine Aufbau einer Halbleiter-Schaltkreisanordnung zu entnehmen. Eine Hauptkomponente derselben ist ein Halbleiter-Chip 1, auf dem eine beliebige Kombination von Halbleiter-Schaltungselementen integriert ist. Auf einer Kopfseite des Halbleiter-Chips 1 ist eine wärmeleitende Keramik-Platte 2 angeordnet. Es kann vorteilhaft sein, wenn zwischen der wärmeleitenden Keramik-Platte 2 und dem Halbleiter-Chip 1 eine thermische Isolierschicht vorgesehen wird, die einen Wärmerücktransport von der Keramik-Platte 2 aus zurück in den Halbleiter-Chip 1 vermindert.

Die Keramik-Platte 2 ist thermisch an den Halbleiter-Chip 1 gekoppelt. Für diese Kopplung sind eine Mehrzahl Bündel 3 aus Nano-Röhrchen 4 vorgesehen, wobei jedes Bündel 3 Nano-Röhrchen 4 unterschiedlicher Länge umfasst. Bekannter Weise zeichnen sich die Nano-Röhrchen 4 durch eine besonders hohe Wärmeleitfähigkeit aus, so dass sie sehr geeignet dafür sind, auf Seiten des Halbleiter-Chips 1 entstehende Wärme zu der Keramik-Platte 2 zu transportieren.

Eine jeweilige erste Stirnseite der Nano-Röhrchen 4 steht in Kontakt mit einer Unterseite der Keramik-Platte 2. Es kann ebenfalls vorteilhaft sein, wenn die Nano-Röhrchen, die bei der dargestellten Ausführungsform beispielsweise mit Hilfe eines Klebers thermisch leitfähig mit der Keramik-Platte 2 verbunden sind, in diese Keramik-Platte 2 hineinragen.

Jeweilige zweite Stirnseiten der Nano-Röhrchen 4 sind innerhalb des Halbleiter-Chips 1 angeordnet, und zwar jeweils in einem Bündel in unterschiedlichen Tiefen. Selbstverständlich ist es möglich, dass innerhalb eines der Bündel 3 auch mehre Nano-Röhrchen 4 derselben Länge vorgesehen sind.

Die Bündel 3 sind im Wesentlichen gleichmäßig unterhalb der Keramik-Platte 2 in dem Halbleiter-Chip 1 angeordnet, so dass ein effektiver Wärmeabtransport aus dem Halbleiter-Chip 1 zu der Keramik-Platte 2 stattfinden kann. Bekanntermaßen entsteht in dem Halbleiter-Chip 1 Wärme aufgrund eines Stromdurchflusses der vorgesehenen integrierten Halbleiter-Schaltungselenente.

Auf der dem Halbleiter-Chip 1 abgewandten Seite der Keramik-Platte 2 sind mehrere Reihenschaltungen 5 von Seebeck-Elementen vorgesehen, wobei die Seebeck-Elemente in Dünnfilm-Technologie ausgeführt sind.

Wie insbesondere aus Figur 2 hervorgeht, sind mehrere Reihenschaltungen 5 von Seebeck-Elementen auf einer Oberfläche der Keramik-Platte 2 parallel zueinander angeordnet und an ihren jeweiligen Stirnseiten elektrisch leitend miteinander verbunden, so dass für die Reihenschaltungen 5 von Seebeck-Elementen untereinander ebenfalls eine Reihenschaltung vorliegt. In der Figur 2 sind zwei Gruppen solcher Reihenschaltungen 5 von Seebeck-Elementen dargestellt, die jeweils eine Thermospannung V₁, V₂ liefern.

Bei alternativen Ausführungsformen der Erfindung können auch mehrere der Reihenschaltungen 5 von Seebeck-Elementen parallel zueinander geschaltet sein, so dass sich ein erhöhter Ladestrom bei im Vergleich zu der vorhergehend erläuterten Ausführungsform verminderter Ladespannung V₁, V₂ ergibt.

Ein Ausführungsbeispiel für das Wachstum von Nano-Röhrchen in vertikaler Richtung innerhalb eines Halbleiter-Chips ist beispielsweise aus der JP 2003 273 112 A bekannt.

Die Figur 3 zeigt eine der Reihenschaltungen 5 von Seebeck-Elementen mehr im Detail. Die Seebeck-Elemente sind in üblicher Weise aufgebaut und weisen jeweils eine erste Wärmekontaktfläche 6, die thermisch an die Keramik-Platte 2 gekoppelt ist, und eine zweite Wärmekontaktfläche 7, die thermisch an ein Wärmereservoir (Luft) gekoppelt ist, auf. Zwischen den beiden Wärmekontaktflächen 6, 7, die jeweils in einem Abstand zueinander liegen, sind jeweils abwechselnd Streifen 23, 12 aus Materialien mit verschiedenen Seebeck-Koeffizienten vorgesehen, so dass jedes einzelne Seebeck-Element eine zugehörige Thermospannung generieren kann. Im vorliegenden Ausführungsbeispiel sind elektrische Kontakte 8, 9 zum Auskoppeln einer Thermo-Ladespannung an den jeweiligen außen liegenden Wärmekontaktflächen 6 vorgesehen.

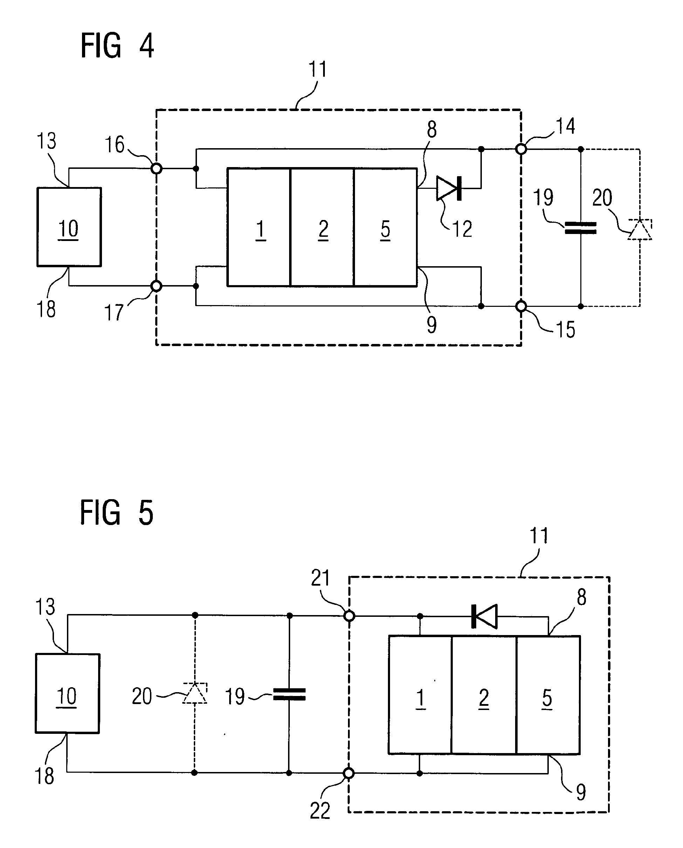

Figur 4 zeigt eine mögliche Schaltungsanordnung für eine Kombination aus einem Akkumulator 10 und der bereits oben erläuterten Halbleiter-Schaltungsanordnung.

In der Figur 4 sind die drei Komponenten, Halbleiter-Chip 1, Keramik-Platte 2 und Seebeck-Reihenschaltungen 5 vereinfacht dargestellt und insgesamt auf einem Haupt-Chip 11 angeordnet. Der elektrische Anschluss 9 ist mit Masse verbunden, während der elektrische Anschluss 8 über eine Diode 12, die ebenfalls auf dem Haupt-Chip 11 integriert ist, mit einem Spannungsanschluss 13 des Akkumulators 10 elektrisch leitend verbunden ist. Die Diode 12 hat die Aufgabe, dass vermieden wird, dass ungewollt ein Stromfluss von dem Akkumulator 10 in die Reihenschaltungen 5 von Seebeck-Elementen stattfinden kann. Aus diesem Grunde liegt die Durchlassrichtung der Diode 12 in Richtung auf den Spannungsanschluss 13 des Akkumulators 10.

Der Haupt-Chip 11 hat insgesamt vier Anschlüsse 14, 15, 16, 17, wobei der Anschluss 16 mit dem Spannungsanschluss 13 des Akkumulators 10 in Verbindung steht, während der Anschluss 17 mit dem Masseanschluss 18 des Akkumulators 10 in Verbindung steht. Der elektrische Anschluss 15 ist ebenfalls ein externer Anschluss des Haupt-Chips 11 und liegt auf Masse. Der elektrische Anschluss 14 ist elektrisch leitend mit dem Anschluss 16 und dem Anschluss 13 verbunden, wobei er hinter der Diode 12 angeordnet ist. Zwischen den Anschlüssen 14, 15 sind parallel zueinander geschaltet eine Kapazität 19 und eine Zehnerdiode 20, die optional vorgesehen werden kann, um einen Schutz des Akkumulators 10 vor Überspannungen durch die von den Reihenschaltungen 5 von Seebeck-Elementen gelieferte Spannung zwischen den elektrischen Kontakten 8, 9 bereitzustellen. Die Zehnerdiode 12 unterstützt diesen Zweck der Spannungsbegrenzung.

Figur 5 zeigt eine abgewandelte Ausführungsform der Kombination von Figur 4, bei der der Haupt-Chip 11 mit insgesamt zwei externen elektrischen Anschlüssen 21, 22 auskommt. Wiederum ist die Diode 12 auf den Haupt-Chip 11 integriert, wobei die Kapazität 19 und die optionale Zehnerdiode 20 wiederum extern vorgesehen sind, allerdings dem Akkumulator 10 unmittelbar benachbart.

Bei den anhand der Figuren 4 und 5 erläuterten Ausführungsformen für Kombinationen der Halbleiter-Schaltungsanordnung und des Akkumulators 10 dienen die Diode 12, die Kapazität 19 und die optionale Zehnerdiode 20 jeweils dem Zweck, eine einfache Version einer Sicherheits- und Stabilisierungsschaltung zur Rückspeisung der mit Hilfe der Reihenschaltungen 5 von Seebeck-Elementen gewonnenen Leistung in den Halbleiter-Chip 1 zu ermöglichen.

## Patentansprüche

1. Halbleiter-Schaltungsanordnung mit integrierten Halbleiter-Schaltungselementen in einem Halbleiter-Chip (1),
**dadurch gekennzeichnet,**
**dass** auf wenigstens einer Seite des Chips, elektrisch isoliert von den Schaltungselementen eine thermisch leitfähige Platte (2) vorgesehen ist, die über eine Mehrzahl von Wärmeleitelementen thermisch an den Chip (1) gekoppelt ist,
auf der dem Chip (1) abgewandten Seite der Platte (2) eine Reihenschaltung (5) von Seebeck-Elementen vorgesehen ist, die jeweils eine erste Wärmekontaktfläche (6), die thermisch mit der Platte (2) gekoppelt ist, und eine zweite Wärmekontaktfläche (7) aufweisen, die thermisch mit einem Wärmereservoir gekoppelt ist, und
elektrische Kontakte (8, 9) für einen Abgriff einer von der Reihenschaltung (5) von Seebeck-Elementen gelieferten Thermospannung (V₁, V₂) vorgesehen sind.

2. Halbleiter-Schaltungsanordnung nach Anspruch 1,
**dadurch gekennzeichnet,**
**dass** die Wärmeleitelemente als Nano-Röhrchen (5) ausgebildet sind.

3. Halbleiter-Schaltungsanordnung nach einem der Ansprüche 1 oder 2,
**dadurch gekennzeichnet,**
**dass** mehrere Wärmeleitelemente gemeinsam ein Bündel (3) bilden, wobei die Wärmeleitelemente eines Bündels (3) verschieden weit in den Chip (1) hineinragen.

4. Halbleiter-Schaltungsanordnung nach einem der Ansprüche 1 bis 3,
**dadurch gekennzeichnet,**
**dass** die Platte (2) aus einer Keramik hergestellt ist.

5. Halbleiter-Schaltungsanordnung nach einem der Ansprüche 1 bis 4,
**dadurch gekennzeichnet,**
**dass** die Reihenschaltung (5) von Seebeck-Elementen entlang einer Linie angeordnet ist.

6. Halbleiter-Schaltungsanordnung nach Anspruch 5,
**dadurch gekennzeichnet,**
**dass** parallel zu der Reihenschaltung (5) von Seebeck-Elementen angeordnete weitere Reihenschaltungen (5) von Seebeck-Elementen vorgesehen sind.

7. Halbleiter-Schaltungsanordnung nach Anspruch 6,
**dadurch gekennzeichnet, dass**
die Reihenschaltungen (5) von Seebeck-Elementen unter sich in Reihe geschaltet sind.

8. Halbleiter-Schaltungsanordnung nach Anspruch 6,
**dadurch gekennzeichnet,**
**dass** die Reihenschaltungen (5) von Seebeck-Elementen unter sich parallel zueinander geschaltet sind.

9. Kombination aus einer Halbleiter-Schaltungsanordnung nach einem der Ansprüche 1 bis 8 und einem Akkumulator (10), dessen Anschlüsse jeweils mit elektrischen Kontakten (8, 9) der Halbleiter-Schaltungsanordnung verbunden sind.

10. Kombination nach Anspruch 9,
bei der der Akkumulator (10) zur Energieversorgung der Halbleiter-Schaltungsanordnung dient.

11. Kombination nach einem der Ansprüche 9 oder 10,
bei der einer der elektrischen Kontakte (8, 9) mit Masse verbunden ist und der andere elektrische Kontakt (8, 9) über eine Diode mit einem Anschluss des Akkumulators verbunden ist, wobei zwischen Masse und einem Anschluss jenseits der Diode eine Kapazität geschaltet ist.

12. Kombination nach Anspruch 11,
bei der parallel zu der Kapazität eine Zehnerdiode geschaltet ist.

13. Kombination nach einem der Ansprüche 11 oder 12,
bei der die Diode auf dem Halbleiter-Chip realisiert ist und die Kapazität extern angeordnet ist.
